# EUROPÄISCHE PATENTSCHRIFT

(11) **EP 3 058 600 B1**
(45) Veröffentlichungstag und Bekanntmachung des Hinweises auf die Patenterteilung: **21.06.2017**
(21) Anmeldenummer: 14772087.4
(22) Anmeldetag: 11.09.2014
(51) Int. Cl.: H01L 41/047, H01L 41/083, H01L 41/297, H01G 4/008, H01G 4/12, H01G 4/30, H01L 41/273

(54) **VIELSCHICHTBAUELEMENT UND VERFAHREN ZUR HERSTELLUNG EINES VIELSCHICHTBAUELEMENTS**
MULTI-LAYER COMPONENT AND METHOD FOR PRODUCING A MULTI-LAYER COMPONENT
ÉLÉMENT MULTICOUCHES ET PROCÉDÉ DE FABRICATION D'UN ÉLÉMENT MULTICOUCHES

(30) Priorität: 17.10.2013 DE 102013017350
(43) Veröffentlichungstag der Anmeldung: 24.08.2016
(73) Patentinhaber: Epcos AG, 81669 München (DE)
(72) Erfinder: GALLER, Martin, A-8401 Kalsdorf (AT)
(74) Vertreter: Epping - Hermann - Fischer
(86) Internationale Anmeldenummer: PCT/EP2014/069420
(87) Internationale Veröffentlichungsnummer: WO 2015/055359

(56) Entgegenhaltungen:
- EP-A1- 2 461 385
- DE-C2- 4 091 418
- DE-C2- 19 860 001
- JP-A- H07 106 654

## Beschreibung

Vielschichtbauelement und Verfahren zur Herstellung eines Vielschichtbauelements.

Es wird ein Vielschichtbauelement und ein Verfahren zur Herstellung eines Vielschichtbauelements angegeben. Beispielsweise ist das Vielschichtbauelement ein Piezoaktor, der zum Betätigen eines Einspritzventils in einem Kraftfahrzeug eingesetzt werden kann. Alternativ kann das Vielschichtbauelement ein Vielschichtkondensator sein.

Vielschichtbauelemente und Verfahren zu Ihrer Herstellung sind aus DE 198 60 001 C2, EP 2 461 385 A, JP 7-106654 A und DE 40 91 418 C2 bekannt.

Es ist eine Aufgabe der Erfindung, ein zuverlässiges Vielschichtbauelement anzugeben. Es ist ferner eine Aufgabe der Erfindung, ein Vielschichtbauelement anzugeben, bei dem Überschläge an den Außenseiten des Vielschichtbauelements verhindert werden. Erfindungsgemäß wird ein Vielschichtbauelement wie durch Anspruch 1 definiert mit einem Grundkörper mit einem Stapel aus alternierend angeordneten dielektrischen Schichten und internen Elektrodenschichten angegeben, außerdem ein Verfahren wie durch Anspruch 4 definiert. In einem Isolationsbereich an den Außenseiten des Grundkörpers ist eine Länge einer Verbindungslinie zwischen gegenpoligen benachbarten internen Elektrodenschichten größer als ein direkter Abstand zwischen den benachbarten Elektrodenschichten. Insbesondere erstreckt sich im Isolationsbereich keine interne Elektrodenschicht bis zu einer Außenseite des Grundkörpers.

Der Isolationsbereich ist ein Bereich, in dem die Außenseiten des Grundkörpers unbedeckt sind. Insbesondere ist im Isolationsbereich keine Außenkontaktierung auf den Grundkörper aufgebracht. Die Länge der Verbindungslinie zwischen gegenpoligen benachbarten internen Elektrodenschichten wird auch als effektiver Abstand bezeichnet. Die Verbindungslinie zwischen den gegenpoligen benachbarten internen Elektrodenschichten verläuft zunächst von einem Ende einer internen Elektrodenschicht auf den kürzest möglichen Pfad zu einer Außenseite des Grundkörpers, an der Außenseite entlang und anschließend wiederum auf dem kürzest möglichen Pfad zum Ende einer gegenpoligen benachbarten internen Elektrodenschicht. Der effektive Abstand ist somit die Länge des kürzest möglichen Pfades zwischen den Elektrodenschichten, der nicht durch das dielektrische Material der dielektrischen Schichten zwischen den Elektrodenschichten führt.

Der direkte Abstand entspricht dem kürzest möglichen Pfad zwischen zwei gegenpoligen benachbarten internen Elektrodenschichten. Dieser Pfad kann durch das dielektrische Material der dielektrischen Schichten führen.

Ein Vielschichtbauelement, bei welchem die Länge der Verbindungslinie zwischen gegenpoligen benachbarten internen Elektrodenschichten an der Außenseite des Grundkörpers größer ist als ein direkter Abstand zwischen den benachbarten Elektrodenschichten hat den Vorteil, dass keine zusätzliche Passivierung, zum Beispiel mit einem elastischen Polymer oder eine Keramik, notwendig ist. Dadurch wird die Lebensdauer des Vielschichtbauelements nicht durch Alterung der Passivierung oder eine Überlast an der Passivierung begrenzt. Insbesondere besteht keine Gefahr eines Passivierungsversagens aufgrund lokaler Überdehnung oder Überhitzung.

Des Weiteren ist eine Performance des Vielschichtbauelements verbessert. Dies kommt dadurch zustande, dass keine Klemmwirkung einer keramischen Passivierung die Funktion des Vielschichtbauelements beeinträchtigt. Des Weiteren ist der Platzbedarf des Vielschichtbauelements durch den Wegfall der Passivierung geringer. Zudem kann eine höhere Geometriegenauigkeit erzielt werden. Dieser Vorteil ergibt sich beispielsweise daraus, dass die Elektroden nachträglich abgetragen oder umgewandelt werden und dass nicht bereits vor dem Sintern eine keramische Passivierung aufgebracht werden muss.

Bei einem wie oben beschriebenen Vielschichtbauelement ist eine elektrische Feldstärke an einer Oberfläche des Vielschichtbauelements reduziert. Die elektrische Feldstärke E berechnet sich nach der Forme E = U/d, wobei U eine angelegte Spannung und d die Länge der Verbindungslinie zwischen gegenpoligen benachbarten internen Elektrodenschichten ist.

Gemäß einer Ausführungsform reichen die dielektrischen Schichten über ihre gesamte Dicke bis zu einer Außenseite des Grundkörpers. Dabei gibt die Dicke der dielektrischen Schichten die Ausdehnung der jeweiligen Schicht in Stapelrichtung an. Dementsprechend reicht jede der dielektrischen Schicht von einer Oberkante, die unmittelbar an eine Elektrodenschicht anschließt, bis zu einer Unterkante, die unmittelbar an die nächste Elektrodenschicht anschließt, bis zu der Außenseite des Grundkörpers.

Gemäß einer Ausführungsform reichen die internen Elektrodenschichten im Isolationsbereich nicht bis zu einer Außenseite des Grundkörpers. Insbesondere sind im Isolationsbereich zwischen den Außenseiten des Grundkörpers und den Enden der internen Elektrodenschichten Luftspalte angeordnet. Erfindungsgemäß ist im Isolationsbereich zwischen den internen Elektrodenschichten und den Außenseiten des Grundkörpers ein Metallsalz als Dielektrikum angeordnet. Bei einem erfindungsgemäßen Verfahren entsteht das Metallsalz während der Herstellung des Vielschichtbauelements durch Umwandlung der internen Elektrodenschichten.

Vorzugsweise sind die dielektrischen Schichten und die dazwischen angeordneten internen Elektrodenschichten entlang einer Stapelrichtung gestapelt. Die Stapelrichtung entspricht vorzugsweise der Längsrichtung des Grundkörpers. Vorzugsweise sind die dielektrischen Schichten und die internen Elektrodenschichten alternierend übereinander gestapelt.

Vorzugsweise enthalten die internen Elektrodenschichten Kupfer oder bestehen aus Kupfer. Alternativ enthalten die internen Elektrodenschichten Silber-Palladium oder bestehen aus Silber-Palladium.

Die dielektrischen Schichten können ein piezoelektrisches Material aufweisen. Beispielsweise können die dielektrischen Schichten ein keramisches Material, insbesondere ein piezokeramisches Material aufweisen. Zur Herstellung des Grundkörpers können Grünfolien verwendet werden, auf die zur Bildung von internen Elektrodenschichten beispielsweise eine Metallpaste aufgebracht wird. Beispielsweise wird die Metallpaste in einem Siebdruckverfahren aufgebracht. Die Metallpaste kann Kupfer enthalten. Alternativ kann die Metallpaste Silber oder Silber-Palladium enthalten. Nach dem Aufbringen der Metallpaste werden die Folien vorzugsweise gestapelt, verpresst und gemeinsam gesintert, sodass ein monolithischer Sinterkörper entsteht. Vorzugsweise wird der Grundkörper des Bauelements durch einen monolithischen Sinterkörper gebildet, beispielsweise durch einen wie oben beschrieben hergestellten Sinterkörper.

Beispielsweise ist das Vielschichtbauelement als piezoelektrisches Bauelement, zum Beispiel als Piezoaktor, ausgebildet. Bei einem Piezoaktor dehnen sich beim Anlegen einer Spannung an die internen Elektrodenschichten zwischen den internen Elektrodenschichten angeordnete piezoelektrische Schichten aus, sodass ein Hub des Piezoaktors erzeugt wird. Das Vielschichtbauelement kann auch als ein anderes Bauelement ausgebildet sein, beispielsweise als Vielschichtkondensator.

Das Vielschichtbauelement weist einen Kontaktierungsbereich auf den Außenseiten des Grundkörpers auf, welcher zum Aufbringen von Außenkontaktierungen vorgesehen ist. In dem Kontaktierungsbereich erstreckt sich zumindest jede zweite interne Elektrodenschicht bis zu der Außenseite des Grundkörpers.

Die Außenkontaktierung dient vorzugsweise zum Anlegen einer Spannung zwischen in Stapelrichtung benachbarten internen Elektrodenschichten. Insbesondere dient die Außenkontaktierung der Zuleitung von Strom zu den internen Elektrodenschichten. Beispielsweise sind zwei Außenelektroden auf gegenüberliegenden Außenseiten des Grundkörpers angeordnet.

Vorzugsweise sind die internen Elektrodenschichten in Stapelrichtung abwechselnd mit einer der Außenelektroden elektrisch verbunden und von der anderen Außenelektrode elektrisch isoliert.

Gemäß einer Ausführungsform sind die internen Elektrodenschichten im Isolationsbereich 250 µm bis 400 µm von den Außenseiten des Grundkörpers beabstandet. Vorzugsweise sind die internen Elektrodenschichten im Isolationsbereich 350 µm von den Außenseiten des Grundkörpers beabstandet.

Die internen Elektrodenschichten können im Isolationsbereich eine geätzte Oberfläche aufweisen.

Des Weiteren wird ein Verfahren zur Herstellung eines Vielschichtbauelements angegeben. Das Verfahren umfasst in einem ersten Schritt das Bereitstellen eines Grundkörpers mit einem Stapel aus alternierend angeordneten dielektrischen Schichten und internen Elektrodenschichten. In einem weiteren Schritt umfasst das Verfahren die Verlängerung der Verbindungslinie zwischen gegenpoligen benachbarten internen Elektrodenschichten an den Außenseiten des Grundkörpers.

Gemäß eines Beispiels wird die Verbindungslinie zwischen den gegenpoligen benachbarten internen Elektrodenschichten an den Außenseiten des Grundkörpers verlängert, indem Elektrodenmaterial abgetragen wird. Erfindungsgemäß wird an den Außenseiten des Grundkörpers Elektrodenmaterial in ein Metallsalz als Dielektrikum umgewandelt.

Das Abtragen oder Umwandeln erfolgt vorzugsweise mittels Eintauchens in eine Säure oder mittels Umsetzung in einer oxidierenden oder nitrierenden Umgebung.

Gemäß einer Ausführungsform wird vor dem Abtragen oder dem Umsetzen des Elektrodenmaterials im Kontaktierungsbereich des Grundkörpers, welcher zum Aufbringen einer Außenkontaktierung vorgesehen ist, eine Blende aufgebracht. Die Blende verhindert einen Abtrag des Elektrodenmaterials im Kontaktierungsbereich. Dadurch kann eine zuverlässige Kontaktierung der internen Elektrodenschichten nach dem Aufbringen einer Außenkontaktierung gewährleistet werden.

In einer weiteren Ausführungsform wird vor dem Abtragen oder dem Umsetzen des Elektrodenmaterials eine Außenkontaktierung auf die Außenseiten des Grundkörpers aufgebracht. Die Außenkontaktierung wird während des Abtragens oder der Umwandlung des Elektrodenmaterials durch eine Blende abgedeckt.

Im Folgenden wird die Erfindung anhand von schematischen Figuren erläutert.
- Figur 1: zeigt einen Längsschnitt durch ein Vielschichtbauelement,
- Figur 2: zeigt einen Längsschnitt durch ein Vielschichtbauelement mit abgetragenen internen Elektrodenschichten,
- Figur 3: zeigt einen Längsschnitt durch ein Vielschichtbauelement vor einer chemischen Behandlung,
- Figur 4: zeigt einen Längsschnitt durch ein Vielschichtbauelement während oder nach einer chemischen Behandlung.

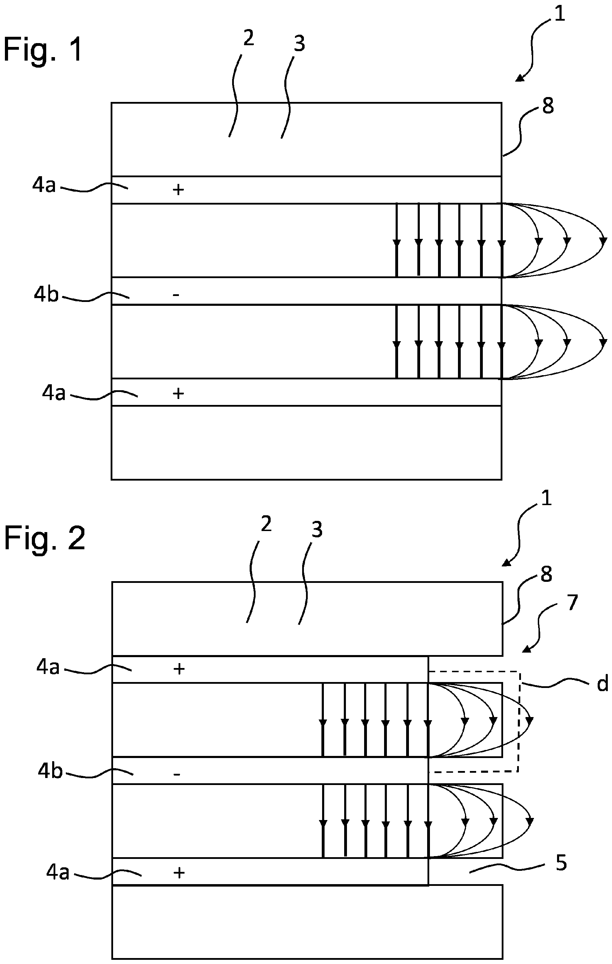

Figur 1 zeigt einen Längsschnitt durch ein Vielschichtbauelement 1. Das Vielschichtbauelement 1 weist einen Grundkörper 2 auf. Der Grundkörper 2 weist einen Stapel aus alternierend angeordneten dielektrischen Schichten 3 und internen Elektrodenschichten 4a, 4b auf. Die dielektrischen Schichten weisen ein piezoelektrisches Material auf. Die internen Elektrodenschichten 4a, 4b sind abwechselnd mit einer ersten und einer zweiten Außenkontaktierung (nicht dargestellt) verbunden. Die erste und zweite Außenkontaktierung weisen jeweils eine unterschiedliche Polarität auf. Insbesondere sind erste interne Elektrodenschichten 4a mit einer Außenkontaktierung einer ersten Polarität verbunden, und interne Elektrodenschichten 4b sind mit einer Außenkontaktierung einer zweiten Polarität verbunden.

Bei einer elektrischen Kontaktierung des Vielschichtbauelements 1 gemäß Figur 1 kommt es bei hohen elektrischen Feldstärken, beispielsweise bei 2 kV/mm, zu elektrischen Überschlägen an den Außenseiten des Grundkörpers 2 zwischen verschieden gepolten internen Elektrodenschichten 4a, 4b.

Solche Überschläge sollen in dem erfindungsgemäßen Vielschichtbauelement verhindert werden.

Figur 2 zeigt ein Vielschichtbauelement 1 in einer Schnittdarstellung. In dem Vielschichtbauelement gemäß Figur 2 sind die ersten und zweiten internen Elektrodenschichten 4a, 4b in einem Isolationsbereich 7 an einer Außenseite 8 des Grundkörpers 2 abgetragen. Insbesondere reichen die internen Elektrodenschichten 4a, 4b nicht bis zu einer Außenseite 8 des Grundkörpers 2. An die Stelle der internen Elektrodenschichten 4a, 4b tritt ein Luftspalt 5. Dadurch ist die elektrische Feldstärke an der Außenseite 8 des Grundkörpers 2 soweit abgesenkt, dass es nicht mehr zu Überschlägen kommt. In einer weiteren Ausführungsform kann der Luftspalt zumindest teilweise mit einem nichtleitenden Material gefüllt sein.

Die elektrische Feldstärke an der Außenseite 8 des Grundkörpers 2 kann abgesenkt werden, indem bei gleichbleibender Spannung ein effektiver Abstand d zwischen benachbarten internen Elektrodenschichten 4a, 4b erhöht wird. Dadurch reduziert sich die elektrische Feldstärke, welche sich aus der Formel E=U/d berechnet. Der effektive Abstand d ist die Länge des kürzest möglichen Pfaden zwischen den Elektrodenschichten 4a, 4b, der nicht durch das dielektrische Material der dielektrischen Schichten 3 zwischen den Elektrodenschichten führt. Im Prinzip führt der Weg mit dem effektiven Abstand d damit an einer Außenseite 8 des Grundkörpers entlang. In Figur 2 ist der Weg mit dem effektiven Abstand d als gestrichelte Linie eingezeichnet. Der effektive Abstand d wird auch als effektive Schichtdicke bezeichnet.

In Figur 2 sind die internen Elektroden 4a, 4b nur auf einer Außenseite abgetragen dargestellt. Jedoch sind in einem möglichen Vielschichtbauelement die internen Elektroden auf der gesamten freiliegenden Außenfläche abgetragen. Die freiliegende Außenfläche ist die Fläche, welche von den Seitenflächen des Grundkörpers gebildet ist, und welche nicht durch eine Außenkontaktierung bedeckt ist. Diese Fläche wird auch als Isolationsbereich 7 bezeichnet.

Ferner reichen die dielektrischen Schichten 3 über ihre gesamte Dicke bis zur Außenseite 8 des Grundkörpers 2.

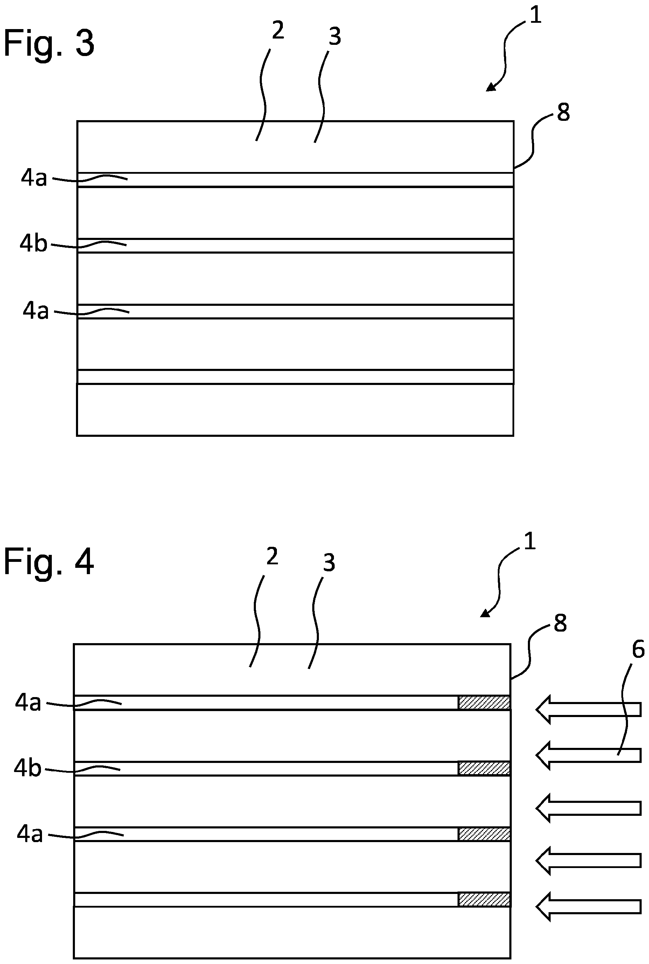

In den Figuren 3 und 4 ist ein Verfahren zur Herstellung eines Vielschichtbauelements 1 veranschaulicht.

Figur 3 zeigt einen Grundkörper 2 eines Vielschichtbauelements 1 vor einer chemischen Behandlung. Eine chemische Behandlung kann ein Abtragen oder ein Umwandeln der internen Elektrodenschichten 4a, 4b beinhalten. Vor der chemischen Behandlung erstrecken sich die internen Elektrodenschichten 4a, 4b bis zur Außenseite des Grundkörpers.

Figur 4 zeigt den Grundkörper 2 während oder nach einer chemischen Behandlung. Die chemische Behandlung erfolgt beispielsweise mittels einer Säure. Der Grundkörper wird dazu in ein Bad mit einer chemischen Substanz, zum Beispiel einer Säure, getaucht. Die internen Elektrodenschichten 4a, 4b werden dabei durch die chemische Substanz angegriffen und soweit gelöst, bis ein erforderlicher effektiver Abstand d zwischen den internen Elektrodenschichten 4a, 4b erreicht ist. Alternativ erfolgt die chemische Behandlung in einer oxidierenden oder nitrierenden Umgebung. Der straffierte Bereich in Figur 4 kennzeichnet dabei den Bereich, in welchem die internen Elektrodenschichten mit der chemischen Substanz reagieren. Die Pfeile 6 sollen das Einwirken der chemischen Substanz darstellen.

Der Abstand der internen Elektrodenschichten 4a, 4b bis zur Außenseite des Grundkörpers 2 beträgt nach der chemischen Behandlung beispielsweise zwischen 290 µm und 390 µm, z. B. 340 µm.

In einer erfindungsgemäßen Ausführungsform werden die internen Elektrodenschichten 4a, 4b durch die chemische Substanz in ein Metallsalz als nichtleitendes Material umgewandelt.

Die chemische Substanz setzt sich zum Beispiel zusammen aus 71% H₂O, 18% HNO_{3(65%)}, 11% Essigsäure_{(99%-100%)}. Der Grundkörper wird beispielsweise 4h in die chemische Substanz eingetaucht.

Ein Kontaktierungsbereich auf den Außenseiten des Grundkörpers 2, welcher zum Aufbringen einer Außenkontaktierung vorgesehen ist, wird vor dem Eintauchen in die chemische Substanz mit einer Blende überdeckt. Ist die Außenkontaktierung bereits vor der chemischen Behandlung auf den Außenseiten des Grundkörpers aufgebracht, wird die Außenkontaktierung mit einer Blende überdeckt und so vor einem Einfluss der chemischen Substanz geschützt.

### Bezugszeichen

- 1: Vielschichtbauelement
- 2: Grundkörper
- 3: dielektrische Schicht
- 4a: interne Elektrodenschicht
- 4b: interne Elektrodenschicht
- 5: Luftspalt
- 6: Pfeile
- 7: Isolationsbereich
- 8: Außenseite
- d: effektiver Abstand

## Patentansprüche

1. Vielschichtbauelement (1), aufweisend einen Grundkörper (2) mit einem Stapel aus alternierend angeordneten dielektrischen Schichten (3) und internen Elektrodenschichten (4a, 4b), wobei in einem Isolationsbereich (7) an den Außenseiten (8) des Grundkörpers (2) eine Länge einer Verbindungslinie (d) zwischen gegenpoligen benachbarten internen Elektrodenschichten (4a, 4b), die zunächst von einem Ende einer internen Elektrodenschicht (4a) auf dem kürzest möglichen Pfad zu einer Außenseite (8) des Grundkörpers (2), an der Außenseite (8) entlang und anschließend wiederum auf dem kürzest möglichen Pfad zum Ende einer gegenpoligen benachbarten internen Elektrodenschicht (4b) verläuft, größer ist als ein direkter Abstand zwischen den benachbarten Elektrodenschichten (4a, 4b),
wobei im Isolationsbereich (7) keine Außenkontaktierung auf den Grundkörper (2) aufgebracht ist,
wobei in einem Kontaktierungsbereich auf den Außenseiten (8) des Grundkörpers (2), welcher zum Aufbringen von Außenkontaktierungen vorgesehen ist, sich zumindest jede zweite interne Elektrodenschicht (4a, 4b) bis zur Außenseite (8) des Grundkörpers (2) erstreckt, **dadurch gekennzeichnet, dass** im Isolationsbereich (7) zwischen den internen Elektrodenschichten (4a, 4b) und den Außenseiten (8) des Grundkörpers (2) ein Metallsalz angeordnet ist.

2. Vielschichtbauelement nach Anspruch 1, wobei die internen Elektrodenschichten (4a, 4b) im Isolationsbereich (7) 250 µm bis 400 µm von einer Außenseite des Grundkörpers (2) beabstandet sind.

3. Vielschichtbauelement nach einem der vorhergehenden Ansprüche, wobei die internen Elektrodenschichten (4a, 4b) im Isolationsbereich (7) eine geätzte Oberfläche aufweisen.

4. Verfahren zur Herstellung eines Vielschichtbauelements (1) umfassend folgende Schritte:
A) Bereitstellen eines Grundkörpers (2) mit einem Stapel aus alternierend angeordneten dielektrischen Schichten (3) und internen Elektrodenschichten (4a, 4b),
B) Verlängerung der Verbindungslinie zwischen gegenpoligen benachbarten internen Elektrodenschichten (4a, 4b) an den Außenseiten des Grundkörpers (2), die zunächst von einem Ende einer internen Elektrodenschicht (4a) auf dem kürzest möglichen Pfad zu einer Außenseite (8) des Grundkörpers (2), an der Außenseite (8) entlang und anschließend wiederum auf dem kürzest möglichen Pfad zum Ende einer gegenpoligen benachbarten internen Elektrodenschicht (4b) verläuft, **dadurch gekennzeichnet, dass** an Außenseiten des Grundkörpers Elektrodenmaterial in ein Metallsalz umgewandelt wird.

5. Verfahren nach dem vorhergehenden Anspruch, wobei die Umwandlung mittels Eintauchens in eine Säure erfolgt oder mittels Umsetzens in einer oxidierenden oder nitrierenden Umgebung erfolgt.

6. Verfahren nach einem der zwei vorhergehenden Ansprüche, wobei in einem Kontaktierungsbereich des Grundkörpers (2), welcher zum Aufbringen einer Außenkontaktierung vorgesehen ist, eine Blende aufgebracht wird, welche einen Abtrag des Elektrodenmaterials verhindert.

7. Verfahren nach einem der Ansprüche 4 bis 6, wobei vor dem Umsetzen des Elektrodenmaterials eine Außenkontaktierung auf die Außenseiten (8) des Grundkörpers (2) aufgebracht wird, und wonach die Außenkontaktierung während der chemischen Behandlung durch eine Blende abgedeckt ist.

## Claims

1. Multi-layer component (1), having a main body (2) comprising a stack of alternately arranged dielectric layers (3) and internal electrode layers (4a, 4b), wherein in an insulation region (7) on the outer sides (8) of the main body (2) a length of a connecting line (d) between adjacent internal electrode layers (4a, 4b) of unlike polarity, which runs first from one end of an internal electrode layer (4a) over the shortest possible path to an outer side (8) of the main body (2), along the outer side (8) and then once again over the shortest possible path to the end of an adjacent internal electrode layer (4b) of unlike polarity, is greater than a direct distance between the adjacent electrode layers (4a, 4b), wherein in the insulation region (7) no outer contacting is applied to the main body (2), wherein in a contacting region on the outer sides (8) of the main body (2) that is intended for applying outer contacting layers at least every second internal electrode layer (4a, 4b) extends as far as the outer side (8) of the main body (2), **characterized in that** in the insulation region (7) a metal salt is arranged between the internal electrode layers (4a, 4b) and the outer sides (8) of the main body (2).

2. Multi-layer component according to Claim 1, wherein in the insulation region (7) the internal electrode layers (4a, 4b) are at a distance of 250 µm to 400 µm from an outer side of the main body (2).

3. Multi-layer component according to one of the preceding claims, wherein in the insulation region (7) the internal electrode layers (4a, 4b) have an etched surface.

4. Method for producing a multi-layer component (1) comprising the following steps:
A) provision of a main body (2) comprising a stack of alternately arranged dielectric layers (3) and internal electrode layers (4a, 4b),
B) extension of the connecting line between adjacent internal electrode layers (4a, 4b) of unlike polarity on the outer sides of the main body (2), which runs first from one end of an internal electrode layer (4a) over the shortest possible path to an outer side (8) of the main body (2), along the outer side (8) and then once again over the shortest possible path to the end of an adjacent internal electrode layer (4b) of unlike polarity,
**characterized in that** on outer sides of the main body electrode material is transformed into a metal salt.

5. Method according to the preceding claim, wherein the transformation is performed by means of immersion in an acid or by means of conversion in an oxidizing or nitriding environment.

6. Method according to one of the two preceding claims, wherein a mask that prevents removal of the electrode material is provided in a contacting region of the main body (2) that is intended for applying an outer contacting.

7. Method according to one of Claims 4 to 6, wherein an outer contacting is applied to the outer sides (8) of the main body (2) before the conversion of the electrode material, and the outer contacting is covered by a mask during the chemical treatment.

## Revendications

1. Elément multicouche (1), présentant un corps de base (2) avec un empilement de couches diélectriques (3) et de couches d'électrode internes (4a, 4b) disposées en alternance, dans lequel, dans une zone d'isolation (7) sur les côtés extérieurs (8) du corps de base (2), une longueur d'une ligne de raccordement (d) entre des couches d'électrode internes voisines (4a, 4b) de polarité opposée, qui s'étend d'abord à partir d'une extrémité d'une couche d'électrode interne (4a) sur le plus court chemin possible jusqu'à un côté extérieur (8) du corps de base (2), le long du côté extérieur (8) et ensuite de nouveau sur le plus court chemin possible jusqu'à l'extrémité d'une couche d'électrode interne voisine (4b) de polarité opposée, est plus grande qu'une distance directe entre les couches d'électrode voisines (4a, 4b),
dans lequel aucun contact extérieur n'est posé sur le corps de base (2) dans la zone d'isolation (7),
dans lequel, dans une zone de contact sur les côtés extérieurs (8) du corps de base (2), qui est prévue pour la pose de contacts extérieurs, au moins chaque deuxième couche d'électrode interne (4a, 4b) s'étend jusqu'au côté extérieur (8) du corps de base (2), **caractérisé en ce qu'**un sel métallique est disposé dans la zone d'isolation (7) entre les couches d'électrode internes (4a, 4b) et les côtés extérieurs (8) du corps de base (2).

2. Elément multicouche selon la revendication 1, dans lequel les couches d'électrode internes (4a, 4b) dans la zone d'isolation (7) sont espacées de 250 µm à 400 µm d'un côté extérieur du corps de base (2).

3. Elément multicouche selon l'une quelconque des revendications précédentes, dans lequel les couches d'électrode internes (4a, 4b) présentent dans la zone d'isolation (7) une surface décapée.

4. Procédé de fabrication d'un élément multicouche (1), comprenant les étapes suivantes:
A) préparer un corps de base (2) avec un empilement de couches diélectriques (3) et de couches d'électrode internes (4a, 4b) disposées en alternance,
B) prolonger la ligne de raccordement entre des couches d'électrode internes voisines (4a, 4b) de polarité opposée sur les côtés extérieurs du corps de base (2), qui s'étend d'abord à partir d'une extrémité d'une couche d'électrode interne (4a) sur le plus court chemin possible jusqu'à un côté extérieur (8) du corps de base (2), le long du côté extérieur (8) et ensuite de nouveau sur le plus court chemin possible jusqu'à l'extrémité d'une couche d'électrode interne voisine (4b) de polarité opposée, **caractérisé en ce que** sur des côtés extérieurs du corps de base, le matériau d'électrode est converti en un sel métallique.

5. Procédé selon la revendication précédente, dans lequel on effectue la conversion par immersion dans un acide ou on effectue la conversion par transformation dans une atmosphère oxydante ou nitrurante.

6. Procédé selon l'une des deux revendications précédentes, dans lequel on applique, dans une zone de contact du corps de base (2), qui est prévue pour la pose d'un contact extérieur, un écran qui empêche un enlèvement du matériau d'électrode.

7. Procédé selon l'une quelconque des revendications 4 à 6, dans lequel on pose un contact extérieur sur les côtés extérieurs (8) du corps de base (2) avant la transformation du matériau d'électrode, et le contact extérieur est ensuite recouvert avec un écran pendant le traitement chimique.
